# FASCICULE DE BREVET EUROPEEN

(11) **EP 2 494 568 B1**
(45) Date de publication et mention de la délivrance du brevet: **25.02.2015**
(21) Numéro de dépôt: 10768249.4
(22) Date de dépôt: 25.10.2010
(51) Int. Cl.: H01H 9/52, F21V 29/00, F28D 15/02, H01L 23/427, H05K 7/20

(54) **DISPOSITIF DE REFROIDISSEMENT D'UN APPAREIL MOYENNE TENSION UTILISANT DES CALODUCS SOUS TENSION**
VORRICHTUNG ZUR KÜHLUNG EINER MITTELSPANNUNGSVORRICHTUNG MIT ISOLIERTEN HEIZROHREN
DEVICE FOR COOLING A MEDIUM-VOLTAGE APPARATUS USING HEAT PIPES UNDER VOLTAGE

(30) Priorité: 26.10.2009 FR 0957481
(43) Date de publication de la demande: 05.09.2012
(73) Titulaire: Alstom Technology Ltd., 5400 Baden (CH)
(72) Inventeur: FRIGIERE, Denis, F-69150 Decines (FR); RODRIGUES, Didier, F-38200 Serpaize (FR); WILLIEME, Jean-Marc, F-69350 La Mulatiere (FR); JACQUIER, Frank, F-69780 Mions (FR)
(74) Mandataire: Ilgart, Jean-Christophe
(86) Numéro de dépôt international: PCT/EP2010/066015
(87) Numéro de publication internationale: WO 2011/051200

(56) Documents cités:
- EP-A1- 1 657 731
- DE-A1- 2 900 761
- DE-A1- 3 941 388
- US-A- 3 662 137

## Description

### Domaine de l'invention

L'invention concerne le domaine des disjoncteurs ou des sectionneurs de générateurs fonctionnant à moyenne tension, placés dans une gaine de protection et utilisant des dispositifs de refroidissement fonctionnant avec un fluide caloporteur à changement de phase, appelés "caloducs".

### Art antérieur et problème posé

Le souci permanent des constructeurs de ce type de matériel est d'augmenter la capacité de ces appareils à passer des courants d'ampérage de plus en plus importants, notamment au niveau des disjoncteurs et sectionneurs placés à l'intérieur de jeux de barres à la sortie de centrales productrices ou de distribution de courant électrique. C'est notamment le cas des disjoncteurs d'alternateurs.

Une méthode, généralement utilisée, consiste à homogénéiser la température de l'air en contact avec les différentes parties chauffantes et chauffées du disjoncteur concerné. Le refroidissement à l'intérieur d'une telle gaine de protection peut se faire par convexion naturelle ou forcée de l'air enfermé dans celle-ci et dans laquelle se trouve le disjoncteur, la température régnant à l'intérieur de celle-ci étant notablement supérieure à la température régnant à l'extérieur, c'est-à-dire de 30°C à au moins 40°C. Toutefois, l'utilisation de tels appareils auxiliaires, tels que des ventilateurs, présente plusieurs inconvénients qui sont une consommation d'énergie électrique élevée sur le circuit principal, un risque de perte de ces ventilateurs auxiliaires d'où une nécessité de les doubler les auxiliaires ou de prévoir des modes de fonctionnement dégradés, des bruits et un fort encombrement.

Une autre solution consiste à prévoir une augmentation de la section de passage du courant dans les différents éléments de transmission, donc de passer par une augmentation de la taille des pièces des disjoncteurs.

D'autre part, par le document de brevet EP 1 657 731, on connaît un dispositif et un procédé de refroidissement d'un disjoncteur ou d'un sectionneur moyenne tension. La figure 1 montre, en coupe, une réalisation décrite dans ce document. Elle représente principalement un conducteur moyenne tension ou le carter d'un disjoncteur. Celui-ci est entouré d'évaporateurs 3 faisant partie d'un ensemble de refroidissement 1 de celui-ci. Un tel ensemble se complète d'un manchon d'isolation 7 entourant un dispositif fonctionnant avec un fluide caloporteur à changement de phase 5 pour évacuer la chaleur collectée par les évaporateurs 3. Un manchon élastique 9 complète l'ensemble. Le tout est placé l'intérieur d'une gaine de protection 8. L'ensemble de refroidissement débouche sur le toit de cette gaine de protection 8 pour aboutir à un dispositif de condensation 4, par exemple à ailettes.

Le but de l'invention est de proposer une solution différente de ce type d'installation.

Le document DE 39 41 388 A1 décrit un dispositif de refroidissement d'un appareil selon le péambule de la revendication 1.

### Résumé de l'invention

A cet effet, l'objet principal de l'invention est un dispositif de refroidissement d'un appareil moyenne tension placé dans une gaine de protection, pour évacuer une partie de la chaleur dispensée par l'appareil, le dispositif comprenant :
- des évaporateurs utilisant des éléments fonctionnant avec un fluide caloporteur à changement de phase, et étant placés autour du carter de l'appareil;
- des condenseurs placés au-dessus de la gaine de protection ; et
- un coffret entourant le dessus de l'ensemble.

Selon l'invention, les évaporateurs et les condenseurs sont en contact électrique avec l'appareil à moyenne tension et on utilise des pièces isolantes pour isoler les condenseurs par rapport au toit de gaine et au coffret.

Dans une réalisation préférentielle, les pièces isolantes, par rapport au toit de la gaine de protection, sont constituées par une partie centrale du toit de cette gaine de protection et sur laquelle les condenseurs reposent.

Dans cette réalisation préférentielle, on utilise des cloisons latérales pour canaliser les flux d'air arrivant latéralement sur les condenseurs.

Dans une réalisation particulière du dispositif selon l'invention, celui-ci peut être complété de moyens de ventilation latérale.

### Liste des figures

L'invention et ses différentes caractéristiques techniques seront mieux comprises à la lecture de la description suivante, accompagnée de plusieurs figures représentant respectivement :
- figure 1, déjà décrite, en coupe, un dispositif de refroidissement d'un appareil moyenne tension, selon l'art antérieur, utilisant des éléments fonctionnant avec un fluide à changement de phase ;
- figure 2, en coupe transversale, une première réalisation du dispositif selon l'invention ;
- figure 3, en coupe transversale, une deuxième réalisation du dispositif selon l'invention ; et
- figure 4, en coupe longitudinale les deux réalisations du dispositif selon l'invention représentées aux figures 2 et 3.

### Description détaillée de deux réalisations de l'invention

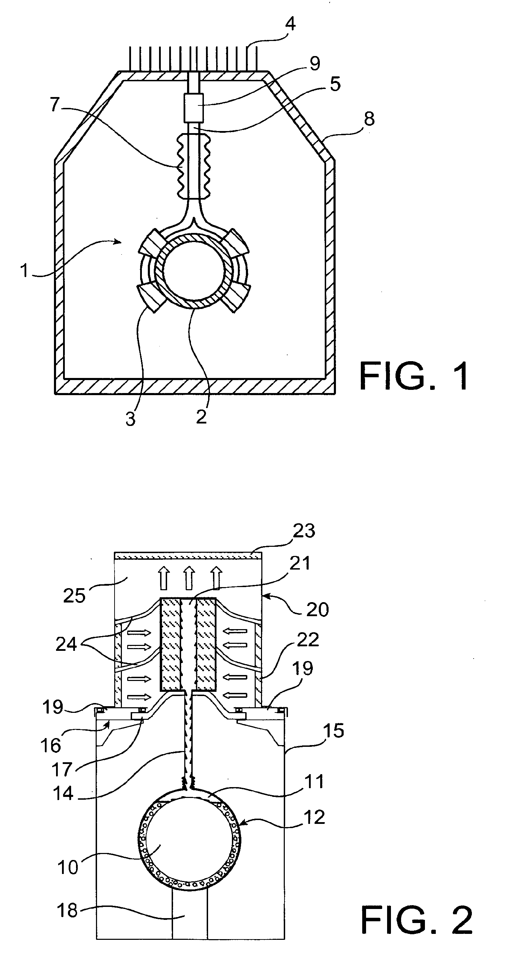

En référence à la figure 2, à l'intérieur d'une gaine 15, se trouve placé, entre autres, un appareil électrique, tel qu'un disjoncteur 10, ou un sectionneur de barre, faisant partie d'une installation de transmission d'énergie électrique sous haute tension. Des évaporateurs 11, à double paroi et contenant un fluide caloporteur à changement de phase, entourent la paroi externe du disjoncteur 10. Ce disjoncteur 10 et ses évaporateurs 11 forment un ensemble placé sous tension 12 et sont supportés à l'intérieur de la gaine 15 par un support isolant 18.

La partie supérieure des évaporateurs 11 est reliée à au moins une canalisation 14 qui traverse le toit 16 de la gaine 15. Chaque canalisation 14 aboutit dans un condenseur 21, placé sur le toit 16 de la gaine 15. Le ou les condenseurs 21 sont eux-mêmes placés dans un coffret 23, placé au-dessus de la gaine 15, et sont soumis à une circulation d'air, notamment par des parois latérales 22 dotées de passages d'air et par un espace supérieur 25 du coffret 20, juste en dessous du toit 23 de celui-ci.

Ainsi, les évaporateurs 11 fonctionnant avec un liquide caloporteur à changement de phase, installés le long des parois du carter du disjoncteur, et éventuellement du sectionneur, permettent d'évacuer une partie de la chaleur de ce dernier, qui est à une température de 100°C. Ces évaporateurs 11 transmettent donc cette chaleur par l'intermédiaire de la canalisation 14 au condenseur 21, placé au-dessus de la gaine. Il faut retenir que les évaporateurs 11, les canalisations 14, et les condenseurs 21 sont en contact électrique avec le disjoncteur 10. Ainsi, il n'est plus nécessaire de s'occuper de leur isolation électrique par rapport à ce dernier.

Tout comme l'ensemble sous tension 12 composé du disjoncteur 10, des évaporateurs 11, des canalisations 14 et des condenseurs 21 est isolé par rapport à la gaine 15, il est prévu que les condenseurs 21 soient également isolés par rapport au toit 16 de la gaine 15 et au coffret 20 et notamment aux parois latérales 22 de ce dernier. Pour ce faire, le toit 16 de la gaine 15 comprend une partie centrale 17 isolante, qui complète deux parties latérales 19 du toit et supporte les condenseurs 21. De plus, des cloisons latérales 24 sont prévues latéralement aux condenseurs 21 par rapport aux parois latérales 22 du coffret 21, pour canaliser les flux d'air ambiant arrivant latéralement sur les condenseurs 21. Ces cloisons latérales de maintien sont en matériau isolant. Ainsi, l'ensemble des éléments de refroidissement du disjoncteur 10 sont isolés électriquement par rapport à l'infrastructure dans laquelle ils sont placés.

On note que les évaporateurs 11, qui entourent les parois du carter du disjoncteur 10, peuvent également être remplacés par des réservoirs rapportés en surface, éventuellement en plusieurs pièces.

Sur cette figure 2, le refroidissement des condenseurs 21 se fait par convexion naturelle.

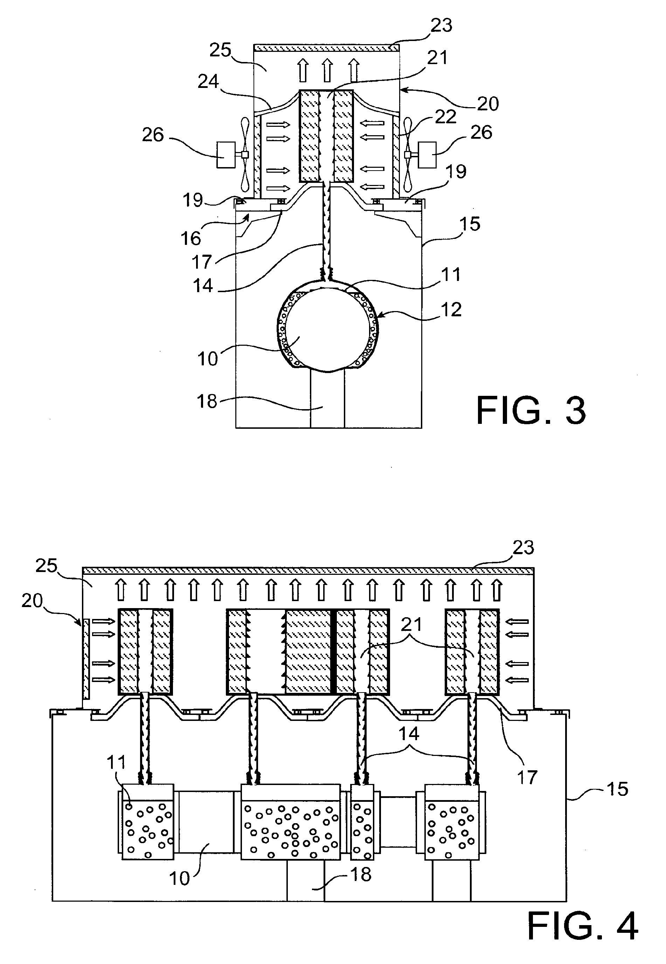

La figure 3 montre une installation similaire, mis à part que des moyens de ventilation latérale 26 sont prévus à l'extérieur du coffret 20, et plus exactement en regard des parois latérales 22. Ainsi, le refroidissement des condenseurs 21 n'est plus assuré par une convexion naturelle, mais par une convexion forcée.

La figure 4 montre en coupe longitudinale des installations, telle que décrites par les figures 2 et 3. On y retrouve un disjoncteur 10 placé sur un support isolant 18 et enfermé dans une gaine 15. Ce disjoncteur 10 fait partie d'un ensemble d'appareils électriques de traitement et de transport du courant électrique moyenne tension, qui bénéficie également du système de refroidissement, selon l'invention, en étant entouré d'évaporateurs 11. Sur cette figure 4, plusieurs canalisations 14 sont représentées aboutissant chacune dans un condenseur 21 placé sur la partie centrale isolante 17 du toit de la gaine 15. Les flèches montrent une circulation d'air longitudinale et horizontale, rentrant par les extrémités droite et gauche et sortant par la partie supérieure du coffret 20.

Les avantages du dispositif selon l'invention sont qu'il ne consomme pas d'énergie et que son développement et sa mise en place ne nécessitent pas d'étudier un système refroidissement isolant, ce qui est un gain de temps, lors du développement d'une telle installation.

## Revendications

1. Dispositif de refroidissement d'un appareil à moyenne tension placé dans une gaine (15), comportant :
- des évaporateurs (11) fonctionnant avec un fluide caloporteur à changement de phase et placés autour du carter de l'appareil (10) ;
- des condenseurs (21) placés au-dessus de la gaine (15) ;
les évaporateurs (11) et les condenseurs (21) sont en contact électrique avec l'appareil à moyenne tension et des pièces isolantes sont prévues pour isoler les condenseurs (10) par rapport au toit (16) de la gaine (15) , **caractérisé en ce qu'**un coffret (20) entoure le dessus de l'ensemble et les pièces isolantes sont prévues pour isoler les condenseurs par rapport au coffret.

2. Dispositif selon la revendication 1, **caractérisé en ce que** les pièces isolantes sont, entre autres, une partie centrale (17) du toit (16) de la gaine (15) pour isoler les condenseurs (21) par rapport au toit (16) de la gaine (15) et sur laquelle ils reposent.

3. Dispositif selon les revendications 1 ou 2, **caractérisé en ce qu'**il comprend des cloisons latérales (24) pour canaliser les flux d'air arrivant latéralement sur les condenseurs (21) du coffret (20).

4. Dispositif selon la revendication 1, **caractérisé en ce qu'**il comprend des moyens de ventilation latérale (26), placés à l'extérieur du coffret (20), en regard de parois latérales (22) du coffret (20).

## Patentansprüche

1. Vorrichtung zur Kühlung einer Mittelspannungseinrichtung, die in einem Mantel (15) angeordnet ist, enthaltend:
- Verdampfer (11), die mit einem Wärmeträgermedium mit Phasenwechsel betrieben werden und um das Gehäuses der Einrichtung (10) herum angeordnet sind;
- Kondensatoren (21), die über dem Mantel (15) angeordnet sind;
wobei die Verdampfer (11) und die Kondensatoren (21) in elektrischem Kontakt mit der Mittelspannungseinrichtung stehend und Isolierteile vorgesehen sind, um die Kondensatoren (10) bezüglich der Abdeckung (16) des Mantels (15) zu isolieren,
**dadurch gekennzeichnet, dass**
ein Kasten (20) die Oberseite der Einheit umgibt und die Isolierteile dazu vorgesehen sind, die Kondensatoren bezüglich des Kastens zu isolieren.

2. Vorrichtung nach Anspruch 1, **dadurch gekennzeichnet, dass** die Isolierteile unter anderem ein Mittelabschnitt (17) der Abdeckung (16) des Mantels (15) sind, um die Kondensatoren (21) bezüglich der Abdeckung (16) des Mantels (15) zu isolieren, auf welchem Mittelabschnitt sie aufliegen.

3. Vorrichtung nach Anspruch 1 oder 2, **dadurch gekennzeichnet, dass** sie seitliche Trennwände (24) aufweist, um die Luftströme zu leiten, die seitlich an den Kondensatoren (21) des Kastens (20) ankommen.

4. Vorrichtung nach Anspruch 1, **dadurch gekennzeichnet, dass** sie seitliche Lüftungsmittel (26) aufweist, die außerhalb des Kastens (20) den Seitenwänden (22) des Kastens (20) gegenüberliegend angeordnet sind.

## Claims

1. A cooling device for cooling medium-voltage switchgear placed inside a sheath (15), comprising:
evaporators (11) operating with a phase-change heat-transfer fluid, and placed about the casing of the switchgear (10);
condensers (21) placed above the sheath (15);
the evaporators (11) and the condensers (21) are in electrical contact with the medium-voltage switchgear and insulating parts are provided for insulating the condensers (10) relative to the roof (16) of the sheath (15) ;
the device being **characterized in that** a box (20) surrounds the top of the assembly and the insulating parts are provided for insulate the condensers with regards the box (20).

2. A device according to claim 1, **characterized in that** the insulating parts include a central portion (17) of the roof (16) of the sheath (15) for insulating the condensers (21) relative to the roof (16) of the sheath (15) and on which they rest.

3. A device according to claim 1 or claim 2, **characterized in that** it includes side partitions (24) for channeling the streams of air reaching the condensers (21) of the box (20) from the side.

4. A device according to claim 1, **characterized in that** it includes side ventilation means (26), which are placed outside the box (20), facing the side walls (22) of the box (20).
